# EUROPEAN PATENT APPLICATION

(11) **EP 4 675 921 A1**
(43) Date of publication of application: **07.01.2026**
(21) Application number: 25187510.0
(22) Date of filing: 04.07.2025
(51) Int. Cl.: H03H 11/24, H03K 19/00, H03K 19/0185, H03K 19/094, H04L 25/02

(54) **SIGNAL ATTENUATOR CIRCUIT USING COMPLEMENTARY SOURCE FOLLOWER CIRCUIT AND PROGRAMMABLE GAIN-TUNING ARRAY CIRCUIT**

(30) Priority: 05.07.2024 US 202463667852 P; 02.07.2025 US 202519257497
(71) Applicant: MEDIATEK INC., Hsinchu City 30078 (TW)
(72) Inventor: PARK, Henry Arnold, San Jose, CA, 95134 (US); ATHARAV, San Jose, CA, 95134 (US); ALI, Tamer Mohammed, San Jose, CA, 95134 (US)
(74) Representative: Pfenning, Meinig & Partner mbB

(57) **Abstract**

A signal attenuator circuit (100) includes a complementary source follower circuit (102) and a programmable gain-tuning array circuit (104). The complementary source follower circuit (102) includes a first transistor and a second transistor. A control terminal of the first transistor is biased by a first bias voltage and receives an input signal of the signal attenuator circuit (100). A control terminal of the second transistor is biased by a second bias voltage and receives the input signal. The first transistor and the second transistor include an N-type transistor and a P-type transistor that are always enabled during a period in which the signal attenuator circuit is in operation. The programmable gain-tuning array circuit (104) is coupled to an output node of the complementary source follower circuit (102), and includes parallel connected cells, each being selectively enabled to adjust an attenuator gain of the signal attenuator circuit (100).

## Description

### Field of the Invention

The present invention relates to an integrated circuit, and more particularly, to a signal attenuator circuit using a complementary (push-pull) source follower circuit and a programmable gain-tuning array circuit.

### Background of the Invention

A high-speed serial system is a communication system where data is transmitted sequentially, bit by bit, at a high bit rate, and includes a transmitter, a serial link, and a receiver. The transmitter may send an output signal with large amplitude. When an input signal with large amplitude is received by an active device (e.g., an amplifier) of the receiver, an output signal of the active device of the receiver may suffer active device's non-linear distortion. Thus, there is a need for an innovative attenuator design which can scale down received signal's magnitude and meet the wideband requirement of the high-speed serial system.

### Summary of the Invention

The scope of the present invention is defined by the claims.

This in mind, the present invention aims at providing a signal attenuator circuit using a complementary (push-pull) source follower circuit and a programmable gain-tuning array circuit.

This is achieved by a signal attenuator circuit according to the independent claim. The dependent claims pertain to corresponding further developments and improvements.

As will be seen more clearly from the detailed description following below, the claimed signal attenuator circuit includes a complementary source follower circuit and a programmable gain-tuning array circuit. The complementary source follower circuit includes a first transistor and a second transistor. A control terminal of the first transistor is biased by a first bias voltage and is configured to receive an input signal of the signal attenuator circuit, a second connection terminal of the first transistor is coupled to a first power rail, and a first connection terminal of the first transistor is coupled to an output node of the complementary source follower circuit. A control terminal of the second transistor is biased by a second bias voltage and is configured to receive the input signal of the signal attenuator circuit, a second connection terminal of the second transistor is coupled to a second power rail, and a first connection terminal of the second transistor is coupled to the output node of the complementary source follower circuit. The first transistor and the second transistor include an N-type transistor and a P-type transistor that are always enabled during a period in which the signal attenuator circuit is in operation. The programmable gain-tuning array circuit is coupled to the output node of the complementary source follower circuit, and includes parallel connected cells, each being selectively enabled to adjust an attenuator gain of the signal attenuator circuit.

### Brief Description of the Drawings

In the following, the invention is further illustrated by way of example, taking reference to the accompanying drawings. Thereof
FIG. 1 is a diagram illustrating a first signal attenuator circuit according to an embodiment of the present invention,
FIG. 2 is a diagram illustrating one implementation of an array with N1 cells shown in FIG. 1 according to an embodiment of the present invention,
FIG. 3 is a diagram illustrating one implementation of an array with N3 cells shown in FIG. 1 according to an embodiment of the present invention,
FIG. 4 is a diagram illustrating one implementation of an array with N2 cells and an array with N4 cells shown in FIG. 1 according to an embodiment of the present invention,
FIG. 5 is a diagram illustrating a second signal attenuator circuit according to an embodiment of the present invention,
FIG. 6 is a diagram illustrating a third signal attenuator circuit according to an embodiment of the present invention,
FIG. 7 is a diagram illustrating a fourth signal attenuator circuit according to an embodiment of the present invention,
FIG. 8 is a diagram illustrating a fifth signal attenuator circuit according to an embodiment of the present invention, and
FIG. 9 is a diagram illustrating a sixth signal attenuator circuit according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

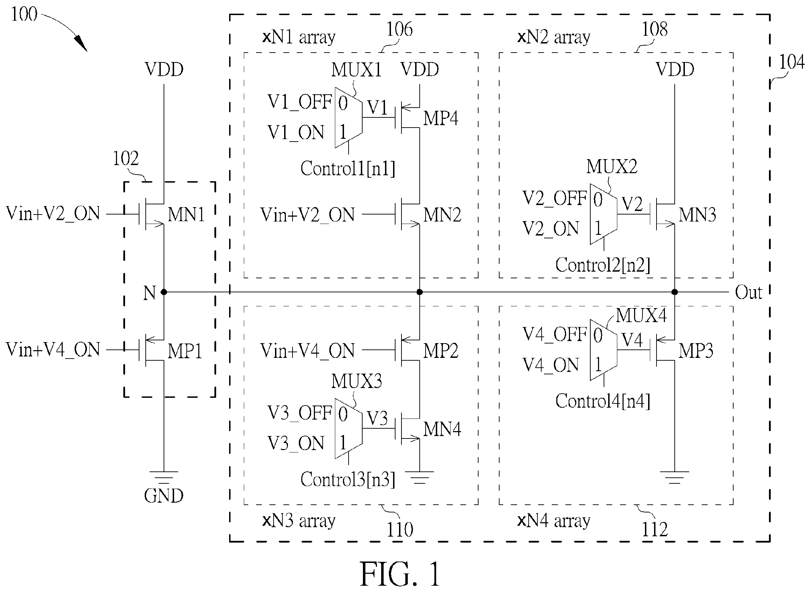

FIG. 1 is a diagram illustrating a first signal attenuator circuit according to an embodiment of the present invention. The signal attenuator circuit 100 may be employed by a receiver of a high-speed serial system. However, this is for illustrative purposes only, and is not meant to be a limitation of the present invention. In practice, any signal processing circuit using the signal attenuator circuit 100 falls within the scope of the present invention. The signal attenuator circuit 100 may include a complementary (push-pull) source follower circuit 102 and a programmable gain-tuning array circuit 104. The complementary (push-pull) source follower circuit 102 includes two transistors MN1 and MP1, where the transistor MN1 is an N-type transistor acting as an N-type source follower, and the transistor MP1 is a P-type transistor acting as a P-type source follower. Device sizes of the transistors MN1 and MP1 may be arbitrary. The transistor MN1 has a control terminal (e.g., a gate terminal), a first connection terminal (e.g., a source terminal), and a second connection terminal (e.g., a drain terminal), where the source terminal is coupled to an output node N of the complementary (push-pull) source follower circuit 102 (which is also an output node of the signal attenuator circuit 100), and the drain terminal is coupled to a power rail on which a supply voltage VDD is delivered. The transistor MP1 has a control terminal (e.g., a gate terminal), a first connection terminal (e.g., a source terminal), and a second connection terminal (e.g., a drain terminal), where the source terminal is coupled to the output node N of the complementary (push-pull) source follower circuit (which is also the output node of the signal attenuator circuit 100), and the drain terminal is coupled to a power rail on which a ground voltage GND is delivered. The complementary (push-pull) source follower circuit 102 has several advantages, including a large gain, low output impedance, high power efficiency, etc. The signal attenuator circuit 100 can benefit from advantages of the complementary (push-pull) source follower circuit 102 that acts as a main signal attenuator. For example, the signal attenuator circuit 100 using the complementary (push-pull) source follower circuit 102 can be a wideband signal attenuator that meets the bandwidth requirement of the high-speed serial system.

In addition, a proper biasing technique may be employed to program a bias voltage V2_ON of the transistor (N-type transistor) MN1 and a bias voltage V4_ON of the transistor (P-type transistor) MP1. In addition, the complementary (push-pull) source follower circuit 102 is configured to receive an input signal (e.g., a high-speed serial input data) Vin of the signal attenuator circuit 100. Hence, a gate voltage (Vin+V2_ON) is present at the gate terminal of the transistor MN1, and a gate voltage (Vin+V4_ON) is present at the gate terminal of the transistor MP1. It should be noted that, with proper setting of the bias voltages V2_ON and V4_ON, the transistors MN1 and MP1 are always enabled during a period in which the signal attenuator circuit 100 is in operation. Furthermore, an output signal Out at the output node N of the complementary (push-pull) source follower circuit 102 will be a linear function of the input signal Vin.

The programmable gain-tuning array circuit 104 is coupled to the output node N of the complementary (push-pull) source follower circuit 102. Specifically, the programmable gain-tuning array circuit 104 includes parallel connected cells, each being selectively enabled to adjust an attenuator gain of the signal attenuator circuit 100. As shown in FIG. 1, the programmable gain-tuning array circuit 104 may include a plurality of arrays 106, 108, 110, and 112, each having a plurality of parallel connected cells.

The array 106 may include N1 (N1 ≥ 2) cells. Each of the N1 cells is coupled between the output node N of the complementary (push-pull) source follower circuit 102 and the power rail on which the supply voltage VDD is delivered, and is selectively enabled. The attenuator gain of the signal attenuator circuit 100 is positively correlated with the number of cells that are enabled in the array 106. In other words, when more cells in the array 106 are enabled, the attenuator gain of the signal attenuator circuit 100 will increase. Each of the N1 cells may have the same circuit structure. For brevity and simplicity, only one cell of the array 106 is illustrated in FIG. 1.

Each cell of the array 106 may include a multiplexer MUX1 and two transistors MP4 and MN2. The multiplexer MUX1 is configured to receive two control voltages V1_OFF and V1_ON (V1_ON < V1_OFF), and output one of the control voltages V1_OFF and V1_ON as a selected control voltage V1. The transistor MP4 is a P-type transistor, and has a control terminal (e.g., a gate terminal), a first connection terminal (e.g., a source terminal), and a second connection terminal (e.g., a drain terminal), where the gate terminal is configured to receive the selected control voltage V1 output from the multiplexer MUX1, and the source terminal is coupled to the power rail on which the supply voltage VDD is delivered. The transistor MN2 is an N-type transistor, and has a control terminal (e.g., a gate terminal), a first connection terminal (e.g., a source terminal), and a second connection terminal (e.g., a drain terminal), where the gate terminal is biased by the bias voltage V2_ON and is configured to receive the input signal Vin of the signal attenuator circuit 100, the drain terminal is coupled to the drain terminal of the transistor MP4, and the source terminal is coupled to the output node N of the complementary (push-pull) source follower circuit 102.

The multiplexer MUX1 is controlled by a control signal Control1[n1], where n1 is selected from [1, 2, ..., N1]. The transistor MP4 is enabled (i.e., turned on) when the selected control voltage V1 is set by the control voltage V1_ON, and is disabled (i.e., turned off) when the selected control voltage V1 is set by the control voltage V1_OFF. Hence, one cell of the array 106 is enabled when both transistors MP4 and MN2 are enabled (i.e., turned on) under a condition that the selected control voltage V1 is set by the control voltage V1_ON, and is disabled when both transistors MP4 and MN2 are disabled (i.e., turned off) under a condition that the selected control voltage V1 is set by the control voltage V1_OFF. Since each cell of the array 106 is driven by the same input signal Vin of the signal attenuator circuit 100, the attenuator gain of the signal attenuator circuit 100 will increase when more cells of the array 106 are enabled.

The array 108 may include N2 (N2 ≥ 2) cells. Each of the N2 cells is coupled between the output node N of the complementary (push-pull) source follower circuit 102 and the power rail on which the supply voltage VDD is delivered, and is selectively enabled. The attenuator gain of the signal attenuator circuit 100 is negatively correlated with the number of cells that are enabled in the array 108. In other words, when more cells in the array 108 are enabled, the attenuator gain of the signal attenuator circuit 100 will decrease. Each of the N2 cells may have the same circuit structure. For brevity and simplicity, only one cell of the array 108 is illustrated in FIG. 1.

Each cell of the array 108 may include a multiplexer MUX2 and a transistor MN3. The multiplexer MUX2 is configured to receive two control voltages V2_OFF and V2_ON (V2_ON > V2_OFF), and output one of the control voltages V2_OFF and V2_ON as a selected control voltage V2. The transistor MN3 is an N-type transistor, and has a control terminal (e.g., a gate terminal), a first connection terminal (e.g., a source terminal), and a second connection terminal (e.g., a drain terminal), where the gate terminal is configured to receive the selected control voltage V2 output from the multiplexer MUX2, the drain terminal is coupled to the power rail on which the supply voltage VDD is delivered, and the source terminal is coupled to the output node N of the complementary (push-pull) source follower circuit 102.

The multiplexer MUX2 is controlled by a control signal Control2[n2], where n2 is selected from [1, 2, ..., N2]. The transistor MN3 is enabled (i.e., turned on) when the selected control voltage V2 is set by the control voltage V2_ON, and is disabled (i.e., turned off) when the selected control voltage V2 is set by the control voltage V2_OFF. Hence, one cell of the array 108 is enabled when the transistor MN3 is enabled (i.e., turned on) under a condition that the selected control voltage V2 is set by the control voltage V2_ON, and is disabled when the transistor MN3 is disabled (i.e., turned off) under a condition that the selected control voltage V2 is set by the control voltage V2_OFF. It should be noted that each cell of the array 108 is a dummy cell that is not driven by the input signal Vin of the signal attenuator circuit 100. Since the transistor MN3 has low output impedance due to its source terminal coupled to the output terminal N of the complementary (push-pull) source follower circuit 102, the attenuator gain of the signal attenuator circuit 100 will decrease when more cells of the array 108 are enabled to make the output terminal N have lower output impedance as well as lower voltage swing.

The array 110 may include N3 (N3 ≥ 2) cells. Each of the N3 cells is coupled between the output node N of the complementary (push-pull) source follower circuit 102 and the power rail on which the ground voltage GND is delivered, and is selectively enabled. The attenuator gain of the signal attenuator circuit 100 is positively correlated with the number of cells that are enabled in the array 110. In other words, when more cells in the array 110 are enabled, the attenuator gain of the signal attenuator circuit 100 will increase. Each of the N3 cells may have the same circuit structure. For brevity and simplicity, only one cell of the array 110 is illustrated in FIG. 1.

Each cell of the array 110 may include a multiplexer MUX3 and two transistors MP2 and MN4. The multiplexer MUX3 is configured to receive two control voltages V3_OFF and V3_ON (V3_ON > V3_OFF), and output one of the control voltages V3_OFF and V3_ON as a selected control voltage V3. The transistor MN4 is an N-type transistor, and has a control terminal (e.g., a gate terminal), a first connection terminal (e.g., a source terminal), and a second connection terminal (e.g., a drain terminal), where the gate terminal is configured to receive the selected control voltage V3 output from the multiplexer MUX3, and the source terminal is coupled to the power rail on which the ground voltage GND is delivered. The transistor MP2 is a P-type transistor, and has a control terminal (e.g., a gate terminal), a first connection terminal (e.g., a source terminal), and a second connection terminal (e.g., a drain terminal), where the gate terminal is biased by the bias voltage V4_ON and is configured to receive the input signal Vin of the signal attenuator circuit 100, the drain terminal is coupled to the drain terminal of the transistor MN4, and the source terminal is coupled to the output node N of the complementary (push-pull) source follower circuit 102.

The multiplexer MUX3 is controlled by a control signal Control3[n3], where n3 is selected from [1, 2, ..., N3]. The transistor MN4 is enabled (i.e., turned on) when the selected control voltage V3 is set by the control voltage V3_ON, and is disabled (i.e., turned off) when the selected control voltage V3 is set by the control voltage V3_OFF. Hence, one cell of the array 110 is enabled when the transistor MN4 is enabled (i.e., turned on) under a condition that the selected control voltage V3 is set by the control voltage V3_ON, and is disabled when the transistor MN4 is disabled (i.e., turned off) under a condition that the selected control voltage V3 is set by the control voltage V3_OFF. Since each cell of the array 110 is driven by the same input signal Vin of the signal attenuator circuit 100, the attenuator gain of the signal attenuator circuit 100 will increase when more cells of the array 110 are enabled.

The array 112 may include N4 (N4 ≥ 2) cells. Each of the N4 cells is coupled between the output node N of the complementary (push-pull) source follower circuit 102 and the power rail on which the ground voltage GND is delivered, and is selectively enabled. The attenuator gain of the signal attenuator circuit 100 is negatively correlated with the number of cells that are enabled in the array 112. In other words, when more cells in the array 112 are enabled, the attenuator gain of the signal attenuator circuit 100 will decrease. Each of the N4 cells may have the same circuit structure. For brevity and simplicity, only one cell of the array 112 is illustrated in FIG. 1.

Each cell of the array 112 may include a multiplexer MUX4 and a transistor MP3. The multiplexer MUX4 is configured to receive two control voltages V4_OFF and V4_ON (V4_ON < V4_OFF), and output one of the control voltages V4_OFF and V4_ON as a selected control voltage V4. The transistor MP3 is a P-type transistor, and has a control terminal (e.g., a gate terminal), a first connection terminal (e.g., a source terminal), and a second connection terminal (e.g., a drain terminal), where the gate terminal is configured to receive the selected control voltage V4 output from the multiplexer MUX4, the drain terminal is coupled to the power rail on which the ground voltage GND is delivered, and the source terminal is coupled to the output node N of the complementary (push-pull) source follower circuit 102.

The multiplexer MUX4 is controlled by a control signal Control4[n4], where n4 is selected from [1, 2, ..., N4]. The transistor MP3 is enabled (i.e., turned on) when the selected control voltage V4 is set by the control voltage V4_ON, and is disabled (i.e., turned off) when the selected control voltage V4 is set by the control voltage V4_OFF. Hence, one cell of the array 112 is enabled when the transistor MP3 is enabled (i.e., turned on) under a condition that the selected control voltage V4 is set by the control voltage V4_ON, and is disabled when the transistor MP3 is disabled (i.e., turned off) under a condition that the selected control voltage V4 is set by the control voltage V4_OFF. It should be noted that each cell of the array 112 is a dummy cell that is not driven by the input signal Vin of the signal attenuator circuit 100. Since the transistor MP3 has low output impedance due to its source terminal coupled to the output terminal N of the complementary (push-pull) source follower circuit 102, the attenuator gain of the signal attenuator circuit 100 will decrease when more cells of the array 112 are enabled to make the output terminal N have lower output impedance as well as lower voltage swing.

It should be noted that the control voltage V1_OFF can be set by any voltage that is high enough to turn off the transistor (P-type transistor) MP4, the control voltage V1_ON can be set by any voltage that is low enough to turn on the transistor (P-type transistor) MP4, the control voltage V2_OFF can be set by any voltage that is low enough to turn off the transistor (N-type transistor) MN3, the control voltage V2_ON can be set by any voltage that is high enough to turn on the transistor (N-type transistor) MN3, the control voltage V3_OFF can be set by any voltage that is low enough to turn off the transistor (N-type transistor) MN4, the control voltage V3_ON can be set by any voltage that is high enough to turn on the transistor (N-type transistor) MN4, the control voltage V4_OFF can be set by any voltage that is high enough to turn off the transistor (P-type transistor) MP3, and the control voltage V4_ON can be set by any voltage that is low enough to turn on the transistor (P-type transistor) MP3.

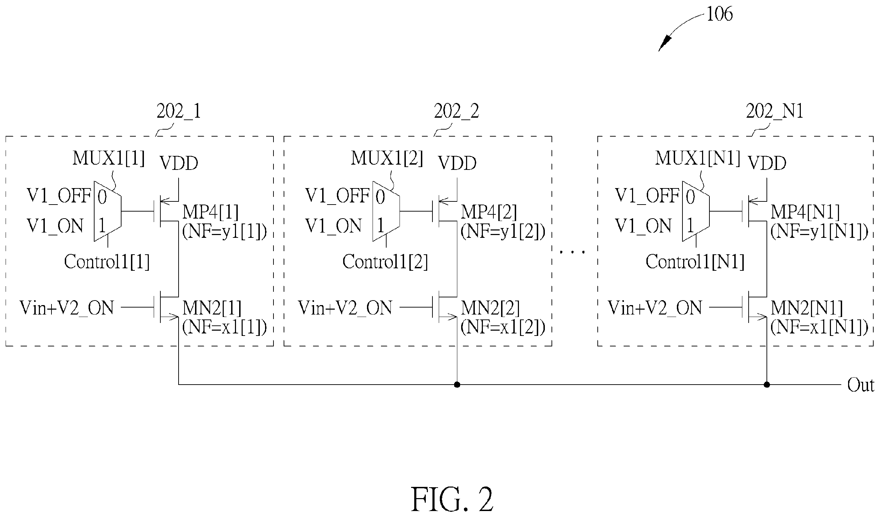

Regarding the array 106 with N1 cells, device sizes of transistors included in the N1 cells may be arbitrary, and multiplexers of the N1 cells may be controlled independently. FIG. 2 is a diagram illustrating one implementation of the array 106 shown in FIG. 1 according to an embodiment of the present invention. The array 106 has cells 202_1-202_N1. Multiplexers MUX1[1]-MUX1[N1] of different cells 202_1-202_N1 are controlled by control signals Control1[1]-Control1[N1], respectively and independently. A device size may vary due to a different number of fingers (NF). Regarding the cell 202_1, the transistor MP4[1] has a device size such as NF=y1[1], and the transistor MN2[1] has a device size such as NF=x1[1]. Regarding the cell 202_2, the transistor MP4[2] has a device size such as NF=y1[2], and the transistor MN2[2] has a device size such as NF=x1[2]. Regarding the cell 202_N1, the transistor MP4[N1] has a device size such as NF=y1[N1], and the transistor MN2[N1] has a device size such as NF=x1[N1]. In some embodiments of the present inventions, transistors MP4[1]-MP4[N1] of different cells 202_1-202_N1 may have the same device size (i.e., y1[1] = y1[2]= ... = y1[N1]), and transistors MN2[1]-MN2[N1] of different cells 202_1-202_N1 may have the same device size (i.e., x1[1] = x1[2] = ... =x1[N1]). In some embodiments of the present inventions, transistors MP4[1]-MP4[N1] of different cells 202_1-202_N1 may have different device sizes (i.e., y1[1] ≠ y1[2] ≠ ...≠ y1[N1]), and transistors MN2[1]-MN2[N1] of different cells 202_1-202_N1 may have different device sizes (i.e., x1[1] ≠ x1[2] ≠ ...≠ x1[N1]). For example, the different device sizes may be binary weighted values.

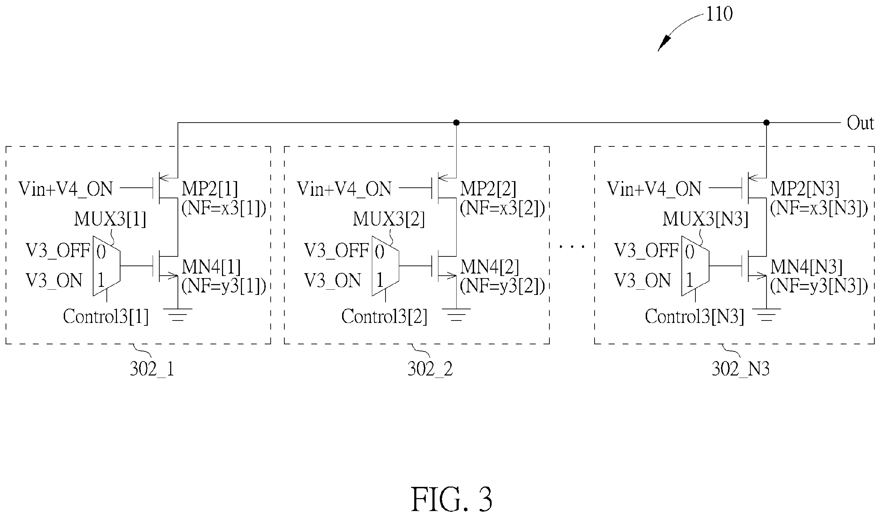

Regarding the array 110 with N3 cells, device sizes of transistors included in the N3 cells may be arbitrary, and multiplexers of the N3 cells may be controlled independently. FIG. 3 is a diagram illustrating one implementation of the array 110 shown in FIG. 1 according to an embodiment of the present invention. The array 110 has cells 302_1-302_N3. Multiplexers MUX3[1]-MUX3[N3] of different cells 302_1-302_N3 are controlled by control signals Control3[1]-Control3[N3], respectively and independently. A device size may vary due to a different NF. Regarding the cell 302_1, the transistor MP2[1] has a device size such as NF=x3[1], and the transistor MN4[1] has a device size such as NF=y3[1]. Regarding the cell 302_2, the transistor MP2[2] has a device size such as NF=x3[2], and the transistor MN4[2] has a device size such as NF=y3[2]. Regarding the cell 302_N3, the transistor MP2[N3] has a device size such as NF=x3[N3], and the transistor MN4[N3] has a device size such as NF=y3[N3]. In some embodiments of the present inventions, transistors MP2[1]-MP2[N3] of different cells 302_1-302_N3 may have the same device size (i.e., x3[1] = x3[2]= ... = x3[N3]), and transistors MN4[1]-MN4[N3] of different cells 302_1-302_N3 may have the same device size (i.e., y3[1] = y3[2] = ... = y3[N3]). In some embodiments of the present inventions, transistors MP2[1]-MP2[N3] of different cells 302_1-302_N3 may have different device sizes (i.e., x3[1] ≠ x3[2] ≠ ...≠ x3[N3]), and transistors MN4[1]-MN4[N3] of different cells 302_1-302_N3 may have different device sizes (i.e., y3[1] ≠ y3[2] ≠ ...≠ y3[N3]). For example, the different device sizes may be binary weighted values.

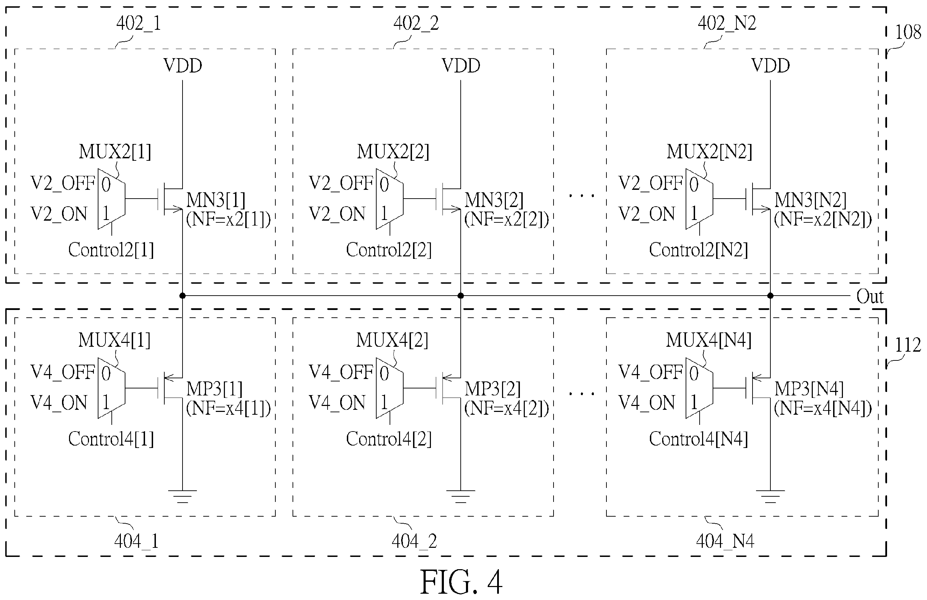

Regarding the array 108 with N2 cells, device sizes of transistors included in the N2 cells may be arbitrary, and multiplexers of the N2 cells may be controlled independently. Regarding the array 112 with N4 cells, device sizes of transistors included in the N4 cells may be arbitrary, and multiplexers of the N4 cells may be controlled independently. FIG. 4 is a diagram illustrating one implementation of the arrays 108 and 112 shown in FIG. 1 according to an embodiment of the present invention. The array 108 has cells 402_1-402_N2. Multiplexers MUX2[1]-MUX2[N2] of different cells 402_1-402_N2 are controlled by control signals Control2[1]-Control2[N2], respectively and independently. A device size may vary due to a different NF. Regarding the cell 402_1, the transistor MN3[1] has a device size such as NF=x2[1]. Regarding the cell 402_2, the transistor MN3[2] has a device size such as NF=x2[2]. Regarding the cell 402_N2, the transistor MN3[N2] has a device size such as NF=x2[N2]. In some embodiments of the present inventions, transistors MN3[1]-MN3[N2] of different cells 402_1-402_N2 may have the same device size (i.e., x2[1] = x2[2]= ... = x2[N2]). In some embodiments of the present inventions, transistors MN3[1]-MN3[N2] of different cells 402_1-402_N2 may have different device sizes (i.e., x2[1] ≠ x2[2] ≠ ...≠ x2[N2]). For example, the different device sizes may be binary weighted values.

The array 112 has cells 404_1-404_N4. Multiplexers MUX4[1]-MUX4[N4] of different cells 404_1-404_N4 are controlled by control signals Control4[1]-Control4[N4], respectively and independently. A device size may vary due to a different NF. Regarding the cell 404_1, the transistor MP3[1] has a device size such as NF=x4[1]. Regarding the cell 404_2, the transistor MP3[2] has a device size such as NF=x4[2]. Regarding the cell 404_N4, the transistor MP3[N4] has a device size such as NF=x4[N4]. In some embodiments of the present inventions, transistors MP3[1]-MP3[N4] of different cells 404_1-404_N4 may have the same device size (i.e., x4[1] = x4[2]= ... = x4[N4]). In some embodiments of the present inventions, transistors MP3[1]-MP3[N4] of different cells 404_1-404_N4 may have different device sizes (i.e., x4[1] ≠ x4[2] ≠ ... ≠ x4[N4]). For example, the different device sizes may be binary weighted values.

In this embodiment shown in FIG. 1, the programmable gain-tuning array circuit 104 is designed to include four arrays 106, 108, 110, 112, where cells of the arrays 106 and 110 are driven by the input signal Vin and can be programed (i.e., enabled or disabled) to increase the attenuator gain of the signal attenuator circuit 100, and cells of the arrays 108 and 112 are not driven by the input signal Vin and can be programed (i.e., enabled or disabled) to decrease the attenuator gain of the signal attenuator circuit 100. However, this is for illustrative purposes only, and is not meant to be a limitation of the present invention. In practice, any attenuator design using one or more of the proposed arrays 106, 108, 110, 112 for attenuator gain tuning falls within the scope of the present invention.

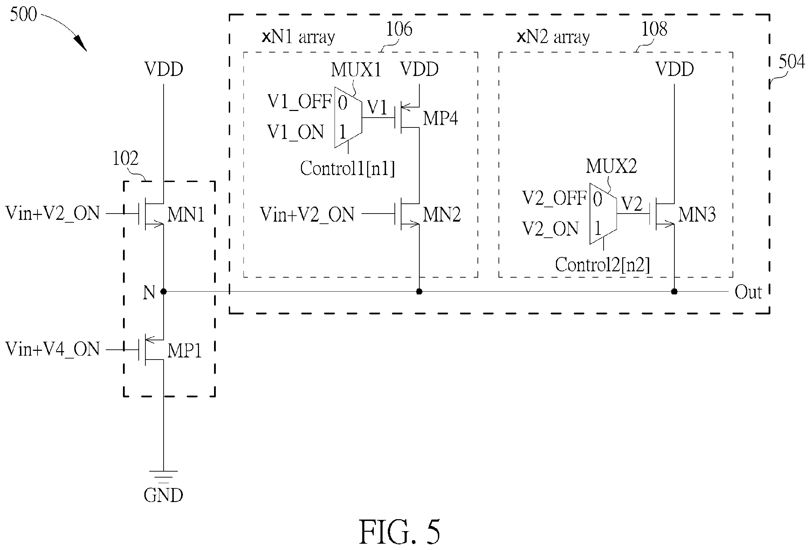

FIG. 5 is a diagram illustrating a second signal attenuator circuit according to an embodiment of the present invention. The difference between the signal attenuator circuits 100 and 500 is that arrays 106 and 108 are implemented in the programmable gain-tuning array circuit 504, but arrays 110 and 112 are absent in the programmable gain-tuning array circuit 504.

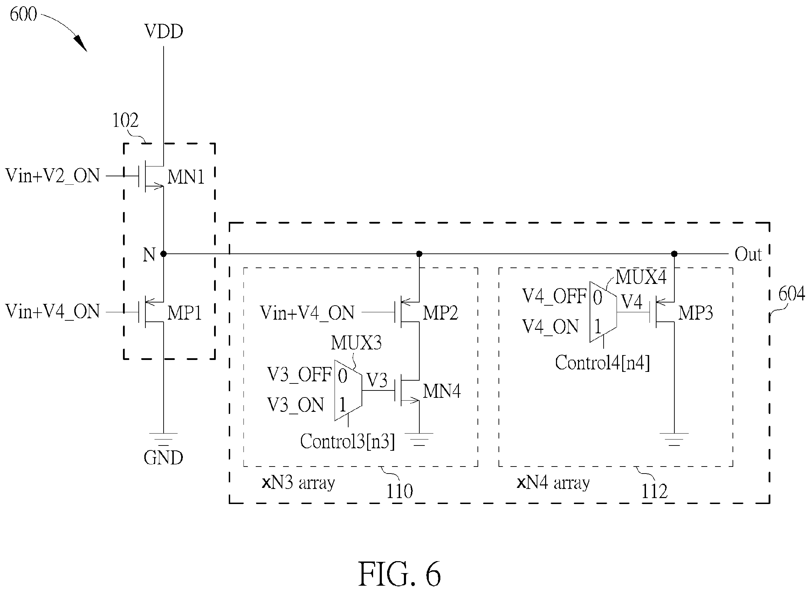

FIG. 6 is a diagram illustrating a third signal attenuator circuit according to an embodiment of the present invention. The difference between the signal attenuator circuits 100 and 600 is that arrays 110 and 112 are implemented in the programmable gain-tuning array circuit 604, but arrays 106 and 108 are absent in the programmable gain-tuning array circuit 604.

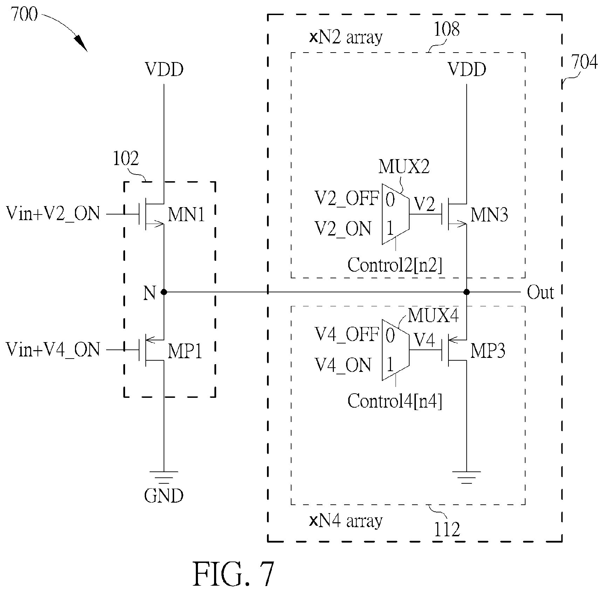

FIG. 7 is a diagram illustrating a fourth signal attenuator circuit according to an embodiment of the present invention. The difference between the signal attenuator circuits 100 and 700 is that arrays 108 and 112 are implemented in the programmable gain-tuning array circuit 704, but arrays 106 and 110 are absent in the programmable gain-tuning array circuit 704.

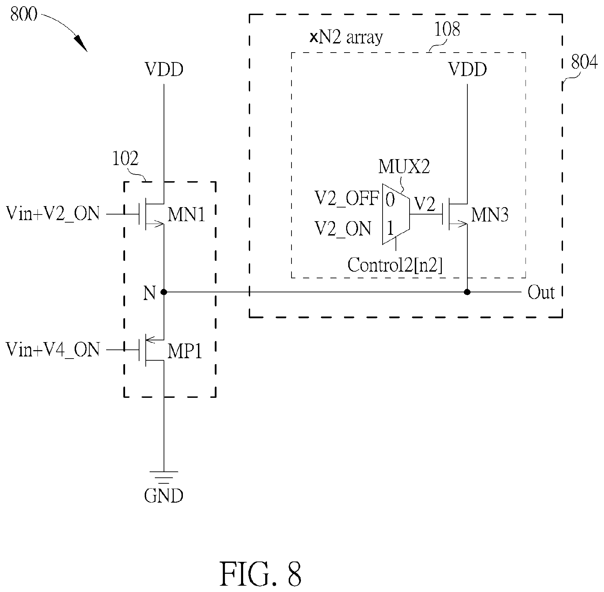

FIG. 8 is a diagram illustrating a fifth signal attenuator circuit according to an embodiment of the present invention. The difference between the signal attenuator circuits 100 and 800 is that the array 108 is implemented in the programmable gain-tuning array circuit 804, but arrays 106, 110, and 112 are absent in the programmable gain-tuning array circuit 804.

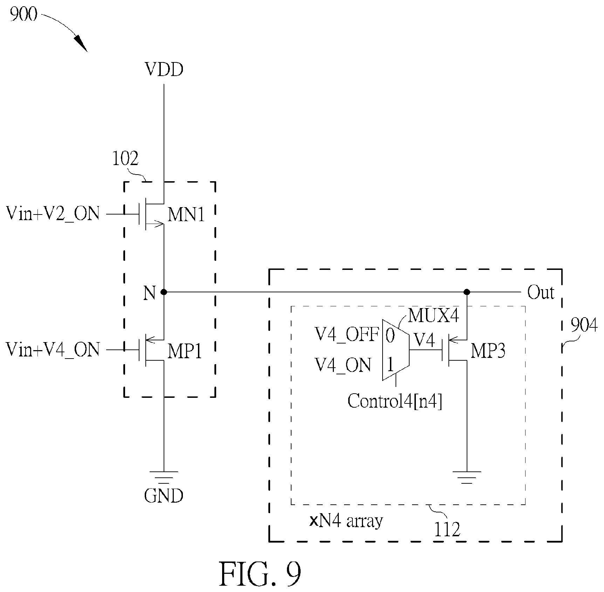

FIG. 9 is a diagram illustrating a sixth signal attenuator circuit according to an embodiment of the present invention. The difference between the signal attenuator circuits 100 and 900 is that the array 112 is implemented in the programmable gain-tuning array circuit 904, but arrays 106, 108, and 110 are absent in the programmable gain-tuning array circuit 904.

Since a person skilled in the art can readily understand details of the signal attenuator circuits 500, 600, 700, 800, 900 after reading above paragraphs directed to the signal attenuator circuit 100, similar description is omitted here for brevity.

## Claims

1. A signal attenuator circuit (100, 500, 600, 700, 800, 900) **characterized by**:
a complementary source follower circuit (102), comprising:
a first transistor (MN1, MP1), having a control terminal, a first connection terminal, and a second connection terminal, wherein the control terminal of the first transistor (MN1, MP1) is biased by a first bias voltage (V2_ON, V4_ON) and is configured to receive an input signal (Vin) of the signal attenuator circuit (100, 500, 600, 700, 800), the second connection terminal of the first transistor (MN1, MP1) is coupled to a first power rail (VDD, GND), and the first connection terminal of the first transistor (MN1, MP1) is coupled to an output node (N) of the complementary source follower circuit (102); and
a second transistor (MP1, MN1), having a control terminal, a first connection terminal, and a second connection terminal, wherein the control terminal of the second transistor (MP1, MN1) is biased by a second bias voltage (V4_ON, V2_ON) and is configured to receive the input signal (Vin) of the signal attenuator circuit (100, 500, 600, 700, 800), the second connection terminal of the second transistor (MP1, MN1) is coupled to a second power rail (GND, VDD), the first connection terminal of the second transistor (MP1, MN1) is coupled to the output node (N) of the complementary source follower circuit (102), and the first transistor and the second transistor comprise an N-type transistor (MN1) and a P-type transistor (MP1) that are always enabled during a period in which the signal attenuator circuit (100, 500, 600, 700, 800) is in operation; and
a programmable gain-tuning array circuit (104, 504, 604, 704, 804, 904), coupled to the output node (N) of the complementary source follower circuit (102), wherein the programmable gain-tuning array circuit (104, 504, 604, 704, 804, 904) comprises parallel connected cells (202_1-202_N1, 302_1-302_N3, 402_1-402_N2, 404_1-404_N4), each being selectively enabled to adjust an attenuator gain of the signal attenuator circuit (100, 500, 600, 700, 800, 900).

2. The signal attenuator circuit (100, 500, 600) of claim 1, **characterized in that** the programmable gain-tuning array circuit (104, 504, 604) comprises:
a first array (106, 110), comprising:
a plurality of first cells (202_1-202_N1, 302_1-302_N3), wherein each of the plurality of first cells (202_1-202_N1, 302_1-302_N3) is coupled between the first power rail (VDD, GND) and the output node (N) of the complementary source follower circuit (102), and is selectively enabled; and the attenuator gain of the signal attenuator circuit (100, 500, 600) is positively correlated with a number of first cells (202_1-202_N1, 302_1-302_N3) that are enabled; and
a second array (108, 112), comprising:
a plurality of second cells (402_1-402_N2, 404_1-404_N4), wherein each of the plurality of second cells (402_1-402_N2, 404_1-404_N4) is coupled between the first power rail (VDD, GND) and the output node (N) of the complementary source follower circuit (102), and is selectively enabled; and the attenuator gain of the signal attenuator circuit (100, 500, 600) is negatively correlated with a number of second cells (402_1-402_N2, 404_1-404_N4) that are enabled.

3. The signal attenuator circuit (100, 500, 600) of claim 2, **characterized in that** each of the plurality of first cells (202_1-202_N1, 302_1-302_N3) comprises:
a multiplexer (MUX1, MUX3), configured to receive a first control voltage (V1_ON, V3_ON) and a second control voltage (V1_OFF, V3_OFF), and output one of the first control voltage (V1_ON, V3_ON) and the second control voltage (V1_OFF, V3_OFF) as a selected control voltage (V1, V3);
a third transistor (MP4, MN4), having a control terminal, a first connection terminal, and a second connection terminal, wherein the control terminal of the third transistor (MP4, MN4) is configured to receive the selected control voltage (V1, V3) output from the multiplexer (MUX1, MUX3), the first connection terminal of the third transistor (MP4, MN4) is coupled to the first power rail (VDD, GND), and the third transistor (MP4, MN4) is enabled when the selected control voltage (V1, V3) is set by the first control voltage (V1_ON, V3_ON), and is disabled when the selected control voltage (V1, V3) is set by the second control voltage (V1_OFF, V3_OFF); and
a fourth transistor (MN2, MP2), having a control terminal, a first connection terminal, and a second connection terminal, wherein the control terminal of the fourth transistor (MN2, MP2) is biased by the first bias voltage (V2_ON, V4_ON) and is configured to receive the input signal (Vin) of the signal attenuator circuit (100, 500, 600), the second connection terminal of the fourth transistor (MN2, MP2) is coupled to the second connection terminal of the third transistor (MP4, MN4), and the first connection terminal of the fourth transistor (MN2, MP2) is coupled to the output node (N) of the complementary source follower circuit (102);
wherein the third transistor (MP4, MN4) and the second transistor (MP1, MN1) have a same transistor type, and the fourth transistor (MN2, MP2) and the first transistor (MN1, MP1) have a same transistor type.

4. The signal attenuator circuit (100, 500, 600) of claim 3, **characterized in that** multiplexers (MUX1, MUX3) of the plurality of first cells (202_1-202_N1, 302_1-302_N3) are controlled independently; or
wherein third transistors (MP4, MN4) of the plurality of first cells (202_1-202_N1, 302_1-302_N3) have different device sizes, and fourth transistors (MN2, MP2) of the plurality of first cells (202_1-202_N1, 302_1-302_N3) have different device sizes; or
wherein third transistors (MP4, MN4) of the plurality of first cells (202_1-202_N1, 302_1-302_N3) have a same device size, and fourth transistors (MN2, MP2) of the plurality of first cells (202_1-202_N1, 302_1-302_N3) have a same device size.

5. The signal attenuator circuit (100, 500, 600) of any one of claims 2 to 4, **characterized in that** each of the plurality of second cells (402_1-402_N2, 404_1-404_N4) comprises:
a multiplexer (MUX2, MUX4), configured to receive a first control voltage (V2_ON, V4_ON) and a second control voltage (V2_OFF, V4_OFF), and output one of the first control voltage (V2_ON, V4_ON) and the second control voltage (V2_OFF, V4_OFF) as a selected control voltage (V2, V4);
a third transistor (MN3, MP3), having a control terminal, a first connection terminal, and a second connection terminal, wherein the control terminal of the third transistor (MN3, MP3) is configured to receive the selected control voltage (V2, V4) output from the multiplexer (MUX2, MUX4), the second connection terminal of the third transistor (MN3, MP3) is coupled to the first power rail (VDD, GND), the first connection terminal of the third transistor (MN3, MP3) is coupled to the output node (N) of the complementary source follower circuit (102), and the third transistor (MN3, MP3) is enabled when the selected control voltage (V2, V4) is set by the first control voltage (V2_ON, V4_ON), and is disabled when the selected control voltage (V2, V4) is set by the second control voltage (V2_OFF, V4_OFF);
wherein the first transistor (MN1, MP1) and the third transistor (MN3, MP3) have a same transistor type.

6. The signal attenuator circuit (100, 500, 600) of claim 5, **characterized in that** multiplexers (MUX2, MUX4) of the plurality of second cells (402_1-402_N2, 404_1-404_N4) are controlled independently; or
wherein third transistors (MN3, MP3) of the plurality of second cells (402_1-402_N2, 404_1-404_N4) have different device sizes; or
wherein third transistors (MN3, MP3) of the plurality of second cells (402_1-402_N2, 404_1-404_N4) have a same device size.

7. The signal attenuator circuit (100, 500) of any one of claims 2 to 6, **characterized in that** the first transistor is the N-type transistor (MN1), the second transistor is the P-type transistor (MP1), and a voltage delivered on the first power rail (VDD) is higher than a voltage delivered on the second power rail (GND).

8. The signal attenuator circuit (100, 600) of any one of claims 2 to 7, **characterized in that** the first transistor is the P-type transistor (MP1), the second transistor is the N-type transistor (MN1), and a voltage delivered on the first power rail (GND) is lower than a voltage delivered on the second power rail (VDD).

9. The signal attenuator circuit (100) of any one of claims 2 to 8, **characterized in that** the programmable gain-tuning array circuit (104) further comprises:
a third array (110, 106), comprising:
a plurality of third cells (302_1-302_N3, 202_1-202_N1), wherein each of the plurality of third cells (302_1-302_N3, 202_1-202_N1) is coupled between the second power rail (GND, VDD) and the output node (N) of the complementary source follower circuit (102), and is selectively enabled; and the attenuator gain of the signal attenuator circuit (100) is positively correlated with a number of third cells (302_1-302_N3, 202_1-202_N1) that are enabled; and
a fourth array (112, 108), comprising:
a plurality of fourth cells (404_1-404_N4, 402_1-402_N2), wherein each of the plurality of fourth cells (404_1-404_N4, 402_1-402_N2) is coupled between the second power rail (GND, VDD) and the output node (N) of the complementary source follower circuit (102), and is selectively enabled; and the attenuator gain of the signal attenuator circuit (100) is negatively correlated with a number of fourth cells (404_1-404_N4, 402_1-402_N2) that are enabled.

10. The signal attenuator circuit (100, 700, 800, 900) of any one of claims 1 to 9, **characterized in that** the programmable gain-tuning array circuit (104, 704, 804, 904) comprises:
a first array (108, 112), comprising:
a plurality of first cells (402_1-402_N2, 404_1-404_N4), wherein each of the plurality of first cells (402_1-402_N2, 404_1-404_N4) is coupled between the first power rail (VDD, GND) and the output node (N) of the complementary source follower circuit (102), and is selectively enabled; and the attenuator gain of the signal attenuator circuit (100, 700, 800) is negatively correlated with a number of first cells (402_1-402_N2, 404_1-404_N4) that are enabled.

11. The signal attenuator circuit (100, 700, 800, 900) of claim 10, **characterized in that** each of the plurality of first cells (402_1-402_N2, 404_1-404_N4) comprises:
a multiplexer (MUX2, MUX4), configured to receive a first control voltage (V2_ON, V4_ON) and a second control voltage (V2_OFF, V4_OFF), and output one of the first control voltage (V2_ON, V4_ON) and the second control voltage (V2_OFF, V4_OFF) as a selected control voltage (V2, V4);
a third transistor (MN3, MP3), having a control terminal, a first connection terminal, and a second connection terminal, wherein the control terminal of the third transistor (MN3, MP3) is configured to receive the selected control voltage (V2, V4) output from the multiplexer (MUX2, MUX4), the second connection terminal of the third transistor (MN3, MP3) is coupled to the first power rail (VDD, GND), the first connection terminal of the third transistor (MN3, MP3) is coupled to the output node (N) of the complementary source follower circuit (102), and the third transistor (MN3, MP3) is enabled when the selected control voltage (V2, V4) is set by the first control voltage (V2_ON, V4_ON), and is disabled when the selected control voltage (V2, V4) is set by the second control voltage (V2_OFF, V4_OFF);
wherein the first transistor (MN1, MP1) and the third transistor (MN3, MP3) have a same transistor type.

12. The signal attenuator circuit (100, 700, 800, 900) of claim 11, **characterized in that** multiplexers (MUX2, MUX4) of the plurality of first cells (402_1-402_N2, 404_1-404_N4) are controlled independently; or
wherein third transistors (MN3, MP3) of the plurality of first cells (402_1-402_N2, 404_1-404_N4) have different device sizes; or
wherein third transistors (MN3, MP3) of the plurality of first cells (402_1-402_N2, 404_1-404_N4) have a same device size.

13. The signal attenuator circuit (100, 700, 800) of any one of claims 10 to 12, **characterized in that** the first transistor is the N-type transistor (MN1), the second transistor is the P-type transistor (MP1), and a voltage delivered on the first power rail (VDD) is higher than a voltage delivered on the second power rail (GND).

14. The signal attenuator circuit (100, 700, 900) of any one of claims 10 to 13, **characterized in that** the first transistor is the P-type transistor (MP1), the second transistor is the N-type transistor (MN1), and a voltage delivered on the first power rail (GND) is lower than a voltage delivered on the second power rail (VDD).

15. The signal attenuator circuit (100, 700) of any one of claims 10 to 14, **characterized in that** the programmable gain-tuning array circuit (704) further comprises:
a second array (112, 108), comprising:
a plurality of second cells (404_1-404_N4, 402_1-402_N2), wherein each of the plurality of second cells (404_1-404_N4, 402_1-402_N2) is coupled between the second power rail (GND, VDD) and the output node (N) of the complementary source follower circuit (102), and is selectively enabled; and the attenuator gain of the signal attenuator circuit (100, 700) is negatively correlated with a number of second cells (404_1-404_N4, 402_1-402_N2) that are enabled.
